Europäisches Patentamt

European Patent Office

Office européen des brevets

(19)

(11) Veröffentlichungsnummer : **0 290 916 B1**

(12) **EUROPÄISCHE PATENTSCHRIFT**

(45) Veröffentlichungstag der Patentschrift :
07.12.94 Patentblatt 94/49

(51) Int. Cl.$^5$ : **G03F 7/11**

(21) Anmeldenummer : **88107059.3**

(22) Anmeldetag : **03.05.88**

(54) **Strahlungsempfindliches Aufzeichnungsmaterial.**

(30) Priorität : **12.05.87 DE 3715790**

(43) Veröffentlichungstag der Anmeldung :
**17.11.88 Patentblatt 88/46**

(45) Bekanntmachung des Hinweises auf die
Patenterteilung :
**07.12.94 Patentblatt 94/49**

(84) Benannte Vertragsstaaten :
**DE GB**

(56) Entgegenhaltungen :
**EP-A- 0 022 571**

(56) Entgegenhaltungen :
**PATENT ABSTRACTS OF JAPAN vol. 7, no. 82
(P-189)(1227), 6 April 1983 ; & JP-A-58 10 734
IBM TECHNICAL DISCLOSURE BULLETIN vol.
26, no. 3B, August 1983, New York, US, Seite
1731 ; C.T. HORNG et al. : "New Resist Combination for Forming a Two-Layer Photoresist
Lift-Off Mask"**

(73) Patentinhaber : **HOECHST
AKTIENGESELLSCHAFT
D-65926 Frankfurt (DE)**

(72) Erfinder : **Elsässer, Andreas, Dr.
Hertastrasse 1b
D-6270 Idstein (DE)**

EP 0 290 916 B1

## Beschreibung

Die Erfindung betrifft ein positiv arbeitendes strahlungsempfindliches Aufzeichnungsmaterial mit einem Schichtträger und einer strahlungsempfindlichen Schicht, die als wesentliche Bestandteile

a) eine unter Einwirkung von aktinischer Strahlung eine starke Säure bildende Verbindung,

b) eine Verbindung mit mindestens einer durch Säure spaltbaren C-O-C-Bindung und

c) ein polymeres Bindemittel

enthält. Das Material ist insbesondere zur Herstellung von Druckplatten und Photoresists geeignet.

Derartige Materialien sind bekannt und z. B. in den US-A 3 915 706, 3 917 483, 3 779 778 und 3 984 253, in den DE-A 26 10 842, 27 18 254 und 30 23 201 und den EP-A 6626, 6627 und 22 571 beschrieben. Sie sind wesentlich lichtempfindlicher als die sonst üblichen positiv arbeitenden strahlungsempfindlichen Aufzeichnungsmaterialien auf Basis von 1,2-Chinondiaziden.

Ein Nachteil dieser Aufzeichnungsmaterialien ist es, daß sie in Verbindung mit den für photolithographische und reprographische Langzeitanwendungen üblichen Trägermaterialien, z. B. Aluminium, Kupfer, Stahl, Zink, Messing, Chrom und Kunststoffolien, keine befriedigende Lagerfähigkeit aufweisen. Die mangelnde Lagerstabilität äußert sich darin, daß die Lichtempfindlichkeit der strahlungsempfindlichen Schichten allmählich abnimmt, bis zuletzt eine einwandfreie Entwicklung der Schichten nicht mehr möglich ist und die Materialien für photolithographische und reprographische Anwendungen nicht mehr zu gebrauchen sind. Häufig geht dieser Abnahme der Lichtempfindlichkeit eine Phase voraus, in der die Lichtempfindlichkeit zunimmt. Diese Erscheinungen werden insbesondere dann beobachtet, wenn die Trägermaterialien zur Verbesserung der Haftung der strahlungsempfindlichen Schicht in allgemein üblicher und bevorzugter Weise mit sauren Mitteln vorbehandelt worden sind. Das gleiche gilt, wenn die Trägermaterialien durch Einwirkung von Luft und/oder Feuchtigkeit an ihrer Oberfläche Reaktionsprodukte mit saurem Charakter gebildet haben.

Dem ungünstigen Einfluß des Trägermaterials kann durch Aufbringen einer Zwischenschicht, welche 1,2-Chinondiazidverbindungen enthält - wie in der älteren Anmeldung DE-A 36 21 376 vorgeschlagen - begegnet werden. Bei der Langzeitlagerung zeigen aber auch diese Materialien einen deutlichen Abfall der Lichtempfindlichkeit und eine Verschlechterung der Entwickelbarkeit.

Aufgabe der Erfindung war es, positiv arbeitende strahlungs- bzw. lichtempfindliche Aufzeichnungsmaterialien auf Basis säurespaltbarer Verbindungen bereitzustellen, die eine bessere Lagerfähigkeit als die bisher bekannten Materialien dieser Art aufweisen.

Erfindungsgemäß wird ein strahlungsempfindliches Aufzeichnungsmaterial der eingangs beschriebenen Gattung vorgeschlagen.

Das erfindungsgemäße Aufzeichnungsmaterial ist dadurch gekennzeichnet, daß sich auf der strahlungsempfindlichen Schicht eine Deckschicht befindet, die ein Polymeres enthält, das beim Entwickeln der strahlungsempfindlichen Schicht zusammen mit den Nichtbildstellen entfernbar ist.

Als strahlungsempfindlich sollen im Rahmen dieser Erfindung alle Systeme bezeichnet werden, die gegen elektromagnetische Strahlung im allgemeinen Sinn, d. h. gegen infrarotes, sichtbares, ultraviolettes Licht, energiereiche Strahlung, wie Röntgen-, Elektronen- und andere Korpuskularstrahlung empfindlich sind. Vorzugsweise liegt die Empfindlichkeit im kurzwelligen sichtbaren oder nahen bis mittleren Ultraviolettbereich. Die durch Bestrahlung Säure bildende Verbindung (a) kann jedoch auch gegenüber Licht, z. B. Tageslicht, beständig und gegenüber Elektronen- oder Röntgenstrahlung empfindlich sein. Auch Laserstrahlung kann ggf. zur Bebilderung eingesetzt werden.

Deckschichten der vorstehend angegebenen Art sind im Prinzip bekannt, und ihre Verwendung als Sauerstoffbarriere in photopolymerisierbaren Aufzeichnungsmaterialien ist z.B. in der GB-A-1 148 362 und in der JP-A 58-10734 beschrieben.

Im Falle der erfindungsgemäßen Aufzeichnungsmaterialien scheint jedoch weniger die Verhinderung des Sauerstoffzutritts zu den strahlungsempfindlichen Schichten von Bedeutung zu sein, da auch sehr dünne Deckschichten, die bekanntermaßen als Sauerstoffbarriere für photopolymerisierbare Schichten nicht mehr ausreichend sind, eine große Verbesserung der Lagerstabilität der erfindungsgemäßen Materialien herbeiführen. Wichtiger ist offensichtlich, daß die Deckschicht für Bestandteile der strahlungsempfindlichen Schicht undurchlässig ist. Neben einer verbesserten Lagerstabilität führen die Deckschichten zu einer Erweiterung des Spielraums für die Nacherwärmung der strahlungsempfindlichen Materialien zwischen Belichtung und Entwicklung und zu einer härteren Gradation. Die bei den strahlungsempfindlichen Materialien auf Basis säurespaltbarer Verbindungen mögliche Positiv-Negativ-Umkehr - wie in der EP-A 82 463 beschrieben - wird durch die Deckschicht nicht ungünstig beeinflußt.

Die Deckschicht sollte bevorzugt in dem Entwickler für die strahlungsempfindliche Schicht löslich sein. In den meisten Fällen haben sich wasserlösliche Polymere als besonders vorteilhafte Deckschichtmaterialien erwiesen. In jedem Fall sollte die Schicht für die zur Bebilderung verwendete Strahlung durchlässig sein.

EP 0 290 916 B1

Zu den geeigneten Polymeren gehören z.B. Polyvinylalkohol und dessen Partialester, Polyvinylether und -acetale, Copolymere aus Vinylalkohol und Olefinen, Gelatine, Gummi arabicum, Polyvinylamide und -lactame wie Polyvinylpyrrolidon oder Polyvinylacetamid, Poly(meth)acrylamide, Polyethylenglykole oder Mischpolymere aus Ethylen- und Propylenoxid, Celluloseether wie Hydroxyethyl- und Carboxymethylcellulose. In manchen Fällen werden auch Gemische von solchen Polymeren eingesetzt.

Zur Verbesserung der Haftung werden den Deckschichten ferner oberflächenaktive Substanzen wie nichtionische, kationische, anionische oder amphotere Tenside zugegeben, z.B. mit Ethylenoxid umgesetzte Alkylphenole sowie Fettsäureester oder Alkyl- oder Arylsulfonate oder Tetraalkylammoniumsalze.

Weiterhin können den Deckschichten Weichmacher, wie Trimethylolpropan oder Neopentylglykol, Pigmente wie $SiO_2$ oder $TiO_2$, um mattierte Deckschichten zu erhalten, sowie Biocide zugesetzt werden. Allgemein sollten in der Deckschicht keine deutlich sauer reagierenden Bestandteile enthalten sein, da diese die Schutzwirkung beeinträchtigen.

Die Schichtdicke dieser Deckschichten wird im allgemeinen so klein wie möglich gewählt, da dicke Deckschichten das Auflösungsvermögen der strahlungsempfindlichen Schicht verschlechtern. Der günstigste Wert für die Dicke der Deckschicht ist im Einzelfall zu ermitteln, auf jeden Fall muß der Wert so hoch sein, daß ein zusammenhängender Film gewährleistet ist. In den meisten Fällen ergeben Schichtdicken zwischen 10 nm und 0,05 mm, vorzugsweise von 100 nm bis 0,01 mm gute Ergebnisse.

Das Aufbringen der Deckschichten erfolgt im allgemeinen aus geeigneten Lösemitteln, bei den bevorzugten Deckschichten aus Wasser oder Wasser-Lösemittelgemischen. Menge und Art des Lösemittels sind so zu wählen, daß ein Anlösen der strahlungsempfindlichen Schicht weitestgehend vermieden wird. Bevorzugt werden als organische Lösemittel Alkohole. Grundsätzlich ist es auch möglich, die Deckschichten in Form von Folien aufzulaminieren.

Die strahlungsempfindliche Schicht ist ihrer Zusammensetzung nach grundsätzlich bekannt. Sie enthält als durch Säure spaltbare Verbindungen in erster Linie:

A) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

B) Oligomer- oder Polymerverbindungen mit wiederkehrenden Acetal- und/oder Ketalgruppierungen in der Hauptkette und

C) Verbindungen mit mindestens einer Enolether- oder N-Acyliminocarbonatgruppierung.

Durch Säure spaltbare Verbindungen des Typs A) als Komponenten strahlungsempfindlicher Gemische sind in der EP-A 0 022 571 ausführlich beschrieben; Gemische, die Verbindungen des Typs B) enthalten, sind in der DE-C 23 06 248 und der DE-C 27 18 254 beschrieben; Verbindungen des Typs C) werden in den EP-A 0 006 626 und 0 006 627 beschrieben.

Der Anteil der spaltbaren Verbindung kann variiert werden zwischen 5 und 70 Gew.-%, bevorzugt werden 5 bis 40 Gew.-%.

Die strahlungsempfindliche Schicht enthält ferner ein polymeres, bevorzugt wasserunlösliches Bindemittel, das in organischen Lösemitteln löslich ist. Da sich als Entwicklerflüssigkeiten für die belichteten Schichten mit Vorteil wäßrig-alkalische Lösungen einsetzen lassen und diese im allgemeinen gegenüber Entwicklern auf Basis organischer Lösemittel vorgezogen werden, werden insbesondere solche Bindemittel bevorzugt, die in wäßrigen Alkalien löslich oder mindestens quellbar sind.

Die Art und Menge der wasserunlöslichen Bindemittel kann je nach Anwendungszweck verschieden sein; bevorzugt sind Anteile am Gesamtfeststoff zwischen 30 und 90, besonders bevorzugt 55 - 85 Gew.-%.

Die bei vielen Positiv-Kopiermaterialien bewährten Phenolharze, vor allem Novolake, haben sich auch bei den erfindungsgemäßen Materialien als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z. B. Kresolen, als Formaldehyd-Kondensationspartner. Die Novolake können auch in bekannter Weise durch Umsetzung eines Teils ihrer Hydroxygruppen, z. B. mit Isocyanaten, Epoxiden oder Carbonsäureanhydriden, modifiziert sein. Andere alkalilösliche Harze sind ebenfalls als Bindemittel geeignet, soweit sie keine freien Säuregruppen enthalten.

Zusätzlich können noch zahlreiche andere Harze mitverwendet werden, die entweder wasserlöslich oder aber alkaliunlöslich sein können, bevorzugt Vinylpolymerisate wie Polyvinylacetate, Polyvinylether und Polyvinylpyrrolidone, die selbst durch Comonomere modifiziert sein können. Der günstigste Anteil an diesen Harzen richtet sich nach den anwendungstechnischen Erfordernissen und dem Einfluß auf die Entwicklungsbedingungen und beträgt im allgemeinen nicht mehr als 20 % vom alkalilöslichen Harz. In geringen Mengen kann die lichtempfindliche Schicht für spezielle Erfordernisse wie Flexibilität, Haftung, Glanz etc. außerdem noch Substanzen wie Polyglykole, Celluloseether, z. B. Ethylcellulose, Netzmittel, Farbstoffe und feinteilige Pigmente enthalten.

EP 0 290 916 B1

Als strahlungsempfindliche Komponenten, die beim Bestrahlen vorzugsweise starke Säuren bilden bzw. abspalten, sind eine große Anzahl von bekannten Verbindungen und Mischungen, wie Diazonium-, Phosphonium-, Sulfonium- und Jodonium-Salze, Halogen-Verbindungen, o-Chinondiazidsulfochloride und Organometall-Organohalogen-Kombinationen geeignet.

Die genannten Diazonium-, Phosphonium-, Sulfonium- und Jodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mehr als einem Halogenatom an einem Kohlenstoffatom oder an einem aromatischen Ring, brauchbar. Beispiele sind in den US-A 3 515 552, 3 536 489 und 3 779 778, der DE-C 26 10 842 und den DE-A 22 43 621, 27 18 259 und 33 37 024 beschrieben. Von diesen Verbindungen werden die s-Triazinderivate mit 2 Halogenmethylgruppen, insbesondere Trichlormethylgruppen, und einem aromatischen bzw. ungesättigten Substituenten im Triazinkern, wie sie in den DE-A 27 18 259 und 33 37 024 beschrieben sind, be vorzugt. Die Wirkung dieser halogenhaltigen Verbindungen kann auch durch bekannte Sensibilisatoren spektral beeinflußt und gesteigert werden.

Beispiele für geeignete Starter sind: 4-(Di-n-propylamino)-benzoldiazoniumtetrafluoroborat, 4-p-Tolylmercapto-2,5-diethoxy-benzoldiazoniumhexafluorophosphat und -tetrafluoroborat, Diphenylamin-4-diazoniumsulfat, 4-Methyl-6-trichlormethyl-2-pyron, 4-(3,4,5-Trimethoxy-styryl)-6-trichlormethyl-2-pyron, 4-(4-Methoxy-styryl)6-(3,3,3-trichlor-propenyl)-2-pyron, 2-Trichlormethylbenzimidazol, 2-Tribrommethyl-chinolin, 2,4-Dimethyl-1-tribromacetyl-benzol, 3-Nitro-1-tribromacetyl-benzol, 4-Dibromacetyl-benzoesäure, 1,4-Bisdibrommethyl-benzol, Tris-dibrommethyl-s-triazin, 2-(6-Methoxy-naphth-2-yl)-, 2-(Naphth-1-yl)-, 2-(Naphth-2-yl)-, 2-(4-Ethoxyethyl-naphth-1-yl)-, 2-(Benzopyran-3-yl)-, 2-(4-Methoxyanthrac-1-yl)-, 2-(4-Styryl-phenyl)-, 2-(Phenanthr-9-yl)-4,6-bis-trichlormethyl-s-triazin und die in den Beispielen angeführten Verbindungen.

Die Menge des Starters kann je nach seiner chemischen Natur und der Zusammensetzung der Schicht ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5 %. Besonders für Kopierschichten von Dicken über 0,01 mm empfiehlt es sich, relativ wenig Säurespender zu verwenden.

Schließlich können der lichtempfindlichen Schicht noch lösliche oder auch feinteilige dispergierbare Farbstoffe sowie je nach Anwendungszweck auch UV-Absorber zugesetzt werden. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Die Schichtdicke der strahlungs- bzw. lichtempfindlichen Schicht richtet sich im wesentlichen nach dem vorgesehenen Anwendungszweck des Materials. Sie kann im allgemeinen zwischen etwa 500 nm und 0,08 mm, vorzugsweise 0,001 bis 0,05 mm liegen. Für Druckplatten und aus Lösungen aufzubringende Photoresistschichten werden Schichtdicken im Bereich von 0,001 bis 0,01 mm bevorzugt.

Zur Beschichtung des Trägermaterials werden die Schichtbestandteile im allgemeinen in einem Lösemittel gelöst. Die Wahl des Lösemittels richtet sich nach dem Beschichtungsverfahren, der Schichtdicke und den Trocknungsbedingungen. Geeignet sind prinzipiell alle Lösemittel, die mit den Schichtbestandteilen verträglich sind, wie z. B. Alkohole, Ketone, Ester, chlorierte Kohlenwasserstoffe etc.. Bevorzugt werden Gemische mit Glykolethern.

Die erfindungsgemäßen Materialien können zur weiteren Stabilisierung der strahlungsempfindlichen Schicht eine Zwischenschicht zwischen dieser und dem Schichtträger enthalten. Materialien aus säurespaltbaren strahlungsempfindlichen Schichten und solchen Zwischenschichten auf Basis von Naphthochinondiaziden sind in der älteren Patentanmeldung EP-A-0 251 059 (DE-A-36 21 376) beschrieben. Diese Zwischenschicht ist normalerweise wesentlich dünner als die säurespaltbare Schicht. Sie hat im allgemeinen eine Dicke von 10 bis 5.000, vorzugsweise zwischen 20 und 5.000 nm. Bei dünnen säurespaltbaren Schichten für Flachdruckplatten und hochauflösende Photoresists werden Zwischenschichten mit 40 bis 500 nm Dicke besonders bevorzugt.

Als o-Chinondiazidverbindungen werden Naphthochinon-(1,2)-diazid-(2)-4-oder -5-sulfonsäureester oder -amide bevorzugt. Von diesen werden die Ester, insbesondere die der 5-Sulfonsäuren, besonders bevorzugt. Geeignete Verbindungen dieser Art sind bekannt und z. B. in der DE-C 938 233, den DE-A 21 31 377, 25 47 905 und 28 28 017 beschrieben.

Der Zwischenschicht werden bevorzugt polymere, wasserunlösliche Bindemittel zugesetzt, die in organischen Lösungsmitteln löslich und in wäßrig-alkalischen Lösungen ebenfalls löslich oder zumindest quellbar sind. Beispielsweise seien genannt: Phenol- oder Kresol-Formaldehydharze, besonders Novolake, welche auch in bekannter Weise durch Umsetzung mit Epoxiden, Isocyanaten, etc. modifiziert sein können. Des weiteren eignen sich Polymere aus Vinylphenol oder Isopropenylphenol, Copolymere dieser Verbindungen mit Al-

4

kylacrylaten, Alkylmethacrylaten, Styrol etc., wie sie in der DE-A 34 06 927 beschrieben sind. Die Menge des Bindemittels ist in weiten Grenzen variierbar; bevorzugt werden jedoch Anteile des Bindemittels von 30-90 Gew.-%, besonders bevorzugt 55-85 Gew.-%.

Die Menge an o-Chinondiazidverbindungen beträgt im allgemeinen 3 bis 50, bevorzugt 7 bis 35 Gew.-%, bezogen auf die nichtflüchtigen Anteile der Schicht.

Zur Anpassung an spezielle Erfordernisse können den Schichten noch Additive wie Weichmacher, z. B. Polyvinylether - wie in der DE-A 16 22 301 beschrieben - oder hydriertes Kolophoniumharz - wie in der DE-A 30 23 201 beschrieben - zugesetzt werden; ferner Haftvermittler, Pigmente, Farbstoffe, Farbbildner und ggf. UV-Absorber.

Als Schichtträger für die lichtempfindlichen Gemische eignen sich alle üblicherweise in der Technik in Kopierprozessen eingesetzten Materialien. Als Beispiele seien Kunststofffolien, Isolierplatten mit Kupferauflage, mechanisch oder elektrochemisch aufgerauhtes und ggf. anodisiertes Aluminium, Siebdruckschablonenträger, Holz, Keramik, Glas und Silicium, dessen Oberfläche chemisch z. B. in Siliciumnitrid oder Siliciumdioxid umgewandelt sein kann, genannt.

Bevorzugte Träger für dicke Schichten über 0,01 mm sind Kunststofffolien, die dann als temporäre Träger für Transferschichten dienen. Dafür und für Farbfolien werden Polyesterfolien, z. B. aus Polyethylenterephthalat, bevorzugt. Polyolefinfolien wie Polypropylen sind jedoch ebenfalls geeignet. Als Schichtträger für Schichtdicken unter ca. 0,01 mm werden meist Metalle verwendet. Für Offsetdruckplatten können eingesetzt werden: mechanisch, chemisch oder elektrolytisch aufgerauhtes und gegebenenfalls anodisiertes Aluminium, das zudem noch chemisch, z. B. mit Polyvinylphosphonsäure, Silikaten oder Phosphaten, vorbehandelt sein kann.

Schließlich kann die Beschichtung direkt oder durch Schichtübertragung vom temporären Schichtträger erfolgen auf Leiterplatten-Materialien, die aus Isolierplatten mit ein- oder beidseitiger Kupferauflage bestehen, auf Glas oder Keramik-Materialien, die gegebenenfalls haftvermittelnd vorbehandelt sind, und auf Silicium-Scheiben.

Für die Trocknung nach der Beschichtung können die üblichen Geräte und Bedingungen übernommen werden, Temperaturen um 100° C und kurzfristig bis 120° C werden ohne Einbuße an Strahlungsempfindlichkeit vertragen.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Mit Vorteil werden Laserbestrahlungsgeräte, insbesondere automatische Verarbeitungsanlagen verwendet, die als Strahlungsquelle einen Argon-Ionen-Laser enthalten.

Die Bestrahlung kann auch mit Elektronenstrahlen erfolgen. In diesem Falle können auch im üblichen Sinne nicht lichtempfindliche Säure bildende Verbindungen als Initiatoren der Solubilisierungsreaktion eingesetzt werden, z. B. halogenierte aromatische Verbindungen oder halogenierte polymere Kohlenwasserstoffe. Röntgen- oder Ionenstrahlen können ebenfalls zur Bilderzeugung verwendet werden.

Die bildmäßig belichtete oder bestrahlte Schicht kann in bekannter Weise mit den für handelsübliche Naphthochinondiazid-Schichten und Kopierlacke bekannten Entwicklern entfernt werden, und die neuen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z. B. Alkaliphosphate, -silikate, -borate oder -hydroxide und ferner Netzmittel sowie ggf. kleinere Anteile organischer Lösungsmittel enthalten. In bestimmten Fällen sind auch Lösemittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwickelten Platten kurze Zeit auf erhöhte Temperaturen erwärmt werden, wie es für Diazoschichten aus der GB-A 1 154 749 bekannt ist.

Im folgenden werden Beispiele für bevorzugte Ausführungsformen des erfindungsgemäßen Aufzeichnungsmaterials angegeben. In den Beispielen stehen Gewichtsteile (Gt) und Volumenteile (Vt) im Verhältnis von g zu ccm. Prozent- und Mengenverhältnisse sind, wenn nichts anderes angegeben ist, in Gewichtseinheiten zu verstehen.

Beispiel 1

Dieses Beispiel zeigt die verbesserte Lagerstabilität der erfindungsgemäßen Aufzeichnungsmaterialien bei unterschiedlichen Lagerbedingungen.

Eine in Salzsäure elektrolytisch aufgerauhte, in Schwefelsäure anodisierte und mit Polyvinylphosphonsäure hydrophilierte Aluminiumplatte wird mit folgender Lösung schleuderbeschichtet:

| | |
|---|---|
| 4,7 Gt | Kresol-Formaldehyd-Novolak (Schmelzpunkt nach Kapillarmethode DIN 53 181: 105-120° C), |
| 1,4 Gt | Polyacetal aus 2-Ethylbutyraldehyd und Triethylenglykol, |
| 0,23 Gt | 2-(4-Styrylphenyl)-4,6-bis-trichlormethyl-s-triazin und |
| 0,02 Gt | Kristallviolett-Base in |
| 93,65 Gt | Butanon. |

Es wird eine Schichtdicke von 1800 nm erhalten. Die Schichten werden 2 Minuten bei 100° C in einem Umluft-trockenschrank getrocknet.

Auf einen Teil der Platten (A) wird die folgende Lösung aufgeschleudert:

| | |
|---|---|
| 4,0 Gt | Polyvinylalkohol (K-Wert 8, 12 % Restacetylgruppen), |
| 1,0 Gt | Polyvinylpyrrolidon, (Luviskol K 30 der BASF AG) |
| 0,05 Gt | p-Nonylphenol-polyoxyethylenether (ca. 10 Oxyethyleneinheiten), |
| 94,95 Gt | destilliertes Wasser |

Es wird eine Schichtdicke von 500 nm nach 2-minütiger Trocknung bei 100° C erhalten. Der andere Teil der Platten (B) wird unverändert belassen und dient als Vergleich.

Die Platten werden unter einer 5-kW-Metallhalogenid-Lampe im Abstand von 110 cm durch einen Halbtonstufenkeil mit 13 Dichtestufen von je 0,15 (Belichtungskeil "BK01" der Hoechst AG) 10 Sekunden belichtet und nach 10 Minuten Warten in einem Entwickler folgender Zusammensetzung 30 Sekunden entwickelt:

| | |
|---|---|
| 8,5 Gt | $Na_2SiO_3$ x 9 $H_2O$, |
| 0,8 Gt | NaOH und |
| 1,5 Gt | $Na_2B_4O_7$ x 12 $H_2O$ in |
| 89,2 Gt | $H_2O$ |

Sowohl bei den Platten vom Typ A, als auch bei den Platten vom Typ B resultiert eine voll gedeckte Stufe 9 nach Anfärbung mit fetter, schwarzer Druckfarbe.

Die Platten werden unter verschiedenen Bedingungen gelagert und der Zeitpunkt bestimmt, zu dem die Platten unter den oben genannten Belichtungs- und Entwicklungsbedingungen nicht mehr vollständig entwickelbar sind und tonen. Tabelle 1 gibt die Ergebnisse wieder.

## Tabelle 1

| | A | B (Vergleich) |
|---|---|---|
| Lagerung bei 100° C | noch tonfrei nach 10 Stunden | Ton nach 6 Stunden |
| Lagerung bei 50° C | noch tonfrei nach 27 Wochen | Ton nach 16 Wochen |

Diese Ergebnisse zeigen auch, daß die 100° C-Lagerung als Prüfverfahren zur Vorhersage der Langzeitlagerstabilität herangezogen werden kann.

### Beispiel 2

Dieses Beispiel zeigt die Eignung des erfindungsgemäßen Aufzeichnungsmaterials mit verschiedenen Trägermaterialien.

Auf verschiedene Trägermaterialien werden zwei Schichten wie in Beispiel 1 aufgeschleudert. Es wird wie in Beispiel 1 belichtet und entwickelt.

| | |
|---|---|
| Träger 1: | in Salpetersäure elektrolytisch aufgerauhte, in Schwefelsäure anodisierte und mit Polyvinylphosphonsäure hydrophilierte Aluminiumplatte, |
| Träger 2: | wie Träger 1, aber ohne Polyvinylphosphonsäurebehandlung, |
| Träger 3: | wie Träger 1, aber mit Polyacrylamid-Lösung hydrophiliert, |
| Träger 4: | mit einer Schleifmittelsuspension mechanisch aufgerauhte und mit Polyvinylphosphonsäure hydrophilierte Aluminiumplatte, |
| Träger 5: | mit Bürsten mechanisch aufgerauhte Kupferplatte, |
| Träger 6: | mechanisch aufgerauhte Zinkplatte, |
| Träger 7: | mit einem $SiO_2$-Film bedeckter Silicium-Wafer, |

Träger 8: mit Polyvinylalkohol und Kieselsäuresol behandelte Polyester-Folie.
Nach zehnstündiger Lagerung bei 100° C erwiesen sich alle Platten als noch tonfrei entwickelbar.

Beispiel 3

Dieses Beispiel zeigt die verbesserte Langzeit-Lagerstabilität des erfindungsgemäßen Aufzeichnungsmaterials im Vergleich zu Aufzeichnungsmaterialien, die anstelle einer Deckschicht eine ein Orthochinondiazid enthaltende Zwischenschicht aufweisen.

In Salzsäure elektrolytisch aufgerauhte, in Schwefelsäure anodisierte und mit Polyvinylphosphonsäure hydrophilierte Aluminiumplatten werden mit folgender Lösung schleuderbeschichtet:

6,6 Gt    Novolak wie in Beispiel 1,
1,6 Gt    Ester aus 3 mol Naphthochinon-(1,2)-diazid-(2)-5-sulfonylchlorid und 1 mol 2,3,4-Trihydroxy-benzophenon und
0,02 Gt   Kristallviolett-Base in
82,0 Gt   Tetrahydrofuran,
65,6 Gt   2-Methoxy-ethanol und
16,4 Gt   Butylacetat.

Die Schichten werden 2 Minuten bei 100° C im Umlufttrockenschrank getrocknet. Anschließend wird jeweils eine zweite lichtempfindliche Schicht der in Beispiel 1 angegebenen Zusammensetzung und ggf. eine Deckschicht wie in Beispiel 1 aufgebracht.

In Tabelle 2 sind aufgeführt die jeweiligen Schichtdicken in nm, die sich dadurch ergebende Belichtungszeit in Sekunden zur Erreichung der gedeckten Stufe 9 und die Veränderung der Platten im 100° C-Lagertest. Entwickelt wird wie in Beispiel 1, nach dem Belichten wird eine Wartezeit von 10 Minuten eingehalten.

## Tabelle 2

|                        | A                    | B                    | C                    |
| ---------------------- | -------------------- | -------------------- | -------------------- |
| 1. Schicht             | -                    | 200                  | 200                  |
| 2. Schicht             | 1.800                | 1.800                | 1.800                |
| 3. Schicht             | 500                  | 500                  | -                    |
| Belichtungszeit        | 10                   | 14                   | 14                   |
| Verhalten bei 100° C-Lagerung | noch tonfrei nach 8 Stunden | noch tonfrei nach 8 Stunden | Ton nach 6 Stunden |

Beispiel 4

Dieses Beispiel zeigt die Wirksamkeit verschiedener Polymere als Deckschicht.

Auf in Salzsäure elektrolytisch aufgerauhte, in Schwefelsäure anodisierte und mit Polyvinylphosphonsäure hydrophilierte Aluminiumplatten wird eine strahlungsempfindliche Schicht wie in Beispiel 1 aufgebracht. Auf diese Schicht wird eine Deckschicht folgender Zusammensetzung durch Schleudern aufgebracht:

5,0 Gt    Polymeres (siehe Tabelle 3)
0,05 Gt   Netzmittel wie in Beispiel 1
94,95 Gt  Wasser

Die Deckschichten sind einheitlich 1.000 nm dick, nachdem sie 2 Minuten bei 100° C getrocknet worden sind. Belichtet und entwickelt wird wie in Beispiel 1. Tabelle 3 gibt die Ergebnisse eines 100° C-Lagertests wieder.

Tabelle 3

| Polymeres | 100° C-Lagertest | Bemerkungen |
|---|---|---|
| Polyvinylalkohol (K-Wert 4, 12 % Restacetylgruppen) | nach 10 Stunden noch tonfrei | - |
| Polyacrylamid (Cyanamer P 250) | " | - |
| Polyvinylpyrrolidon (Luviskol K 30 der BASF AG) | " | Entwicklung etwas be- einträchtigt |
| Poly-N-vinyl-N-methyl-acetamid | " | " |
| Polyglykol 100.000 | " | Entwicklung in Fladen |
| Polyvinylmethylether (Lutonal M 40 der BASF AG)[1] | " | " |

Fortsetzung Tabelle 3

| Polymeres | 100° C-Lagertest | Bemerkungen |
|---|---|---|
| Hydroxyethylcellu- lose (Tylose H 10 der Hoechst AG) | nach 10 Stunden leichte Tonneigung | - |
| Gummi arabicum | " | - |

[1] bei der Aufbringung dieser Deckschicht muß in der Beschichtungslösung 1/10 des destillierten Wassers durch Methanol ersetzt werden.

Beispiel 5

Dieses Beispiel zeigt die Eignung des erfindungsgemäßen Aufzeichnungsmaterials zur Herstellung von Flachdruckplatten.

Auf eine in Salzsäure elektrolytisch aufgerauhte, in Schwefelsäure anodisierte und in Polyvinylphosphonsäure hydrophilierte Aluminiumplatte wird eine strahlungsempfindliche Schicht folgender Zusammensetzung aufgeschleu-dert:

| | |
|---|---|
| 4,0 Gt | Novolak wie in Beispiel 1, |
| 1,2 Gt | Polymerer Orthoester aus 4-Oxa-6,6-bis-hydroxymethyl-octan-1-ol und Orthoameisensäuretriethylester, |
| 0,20 Gt | 2-(4-Styrylphenyl)-4,6-bis-trichlormethyl-s-triazin und |
| 0,02 Gt | Kristallviolett-Base in |
| 94,60 Gt | Butanon. |

Nach 2 Minuten Trocknen bei 100° C resultiert eine Schichtdicke von 2000 nm. Hierauf wird eine Lösung aus

| | |
|---|---|
| 4,0 Gt | des in Beispiel 4 angegebenen Polyvinylalkohols |
| 1,0 Gt | Poly-N-vinyl-N-methyl-acetamid, |
| 0,05 Gt | feinteilige Kieselsäure mit einem mittleren Teilchendurchmesser von 0,008 mm und |
| 0,05 Gt | Cocosfettalkoholpolyoxyethylenether (ca. 5-20 Oxyethyleneinheiten) in |
| 94,9 Gt | Wasser |

aufgeschleudert und ebenfalls 2 Minuten bei 100° C getrocknet. Es resultiert eine Schichtdicke der Deckschicht von 700 nm.

Es wird wie in Beispiel 1 bildmäßig belichtet und entwickelt. Mit der so hergestellten Offsetdruckform werden 60.000 Drucke einwandfreier Qualität erhalten.

Beispiel 6

Dieses Beispiel zeigt den breiteren Spielraum des erfindungsgemäßen Aufzeichnungsmaterials bei der Nacherwärmung im Vergleich mit Materialien ohne Deckschicht.

Entsprechend Beispiel 1 werden Träger mit strahlungsempfindlicher Schicht beschichtet, und ein Teil der Platten mit einer Deckschicht wie in Beispiel 5 versehen (A). Die übrigen Platten werden ohne Deckschicht belassen (B).

Die Platten werden wie in Beispiel 1 belichtet und entwickelt, jedoch werden sie statt des 10-minütigen Wartens bei Raumtemperatur zwischen Belichtung und Entwicklung 1 Minute auf verschiedene Temperaturen erwärmt (Tabelle 4) und nach Anfärbung mit fetter, schwarzer Druckfarbe die im Halbtonstufenkeil wiedergegebenen Stufen von voll gedeckt bis erstmals farbannehmend bestimmt.

Tabelle 4

| | 60° C | 70° C | 80° C | 90° C | 100° C |
|---|---|---|---|---|---|
| A | 8 - 5 | 9 - 6 | 9 - 6 | 9 - 6 | 9 - 6 |
| B | 8 - 4 | 9 - 5 | 9 - 5 | 8 - 4, leichte Tonneigung | Ton |

Neben der größeren Konstanz der Ergebnisse bei den Platten mit der erfindungsgemäßen Deckschicht zeigen die Werte auch, daß die Gradation durch Verwendung einer Deckschicht härter wird.

Beispiel 7

Dieses Beispiel zeigt, daß das erfindungsgemäße Aufzeichnungsmaterial auch zur Bildumkehr geeignet ist.

Platten wie in Beispiel 5 mit (A) und ohne (B) Deckschicht werden unter einer Positivvorlage wie in Beispiel 1 10 Sekunden belichtet, 2 Minuten auf 140° C erhitzt und ganzflächig 10 Sekunden nachbelichtet.

Nach der Entwicklung mit dem Entwickler aus Beispiel 1 erhält man ein negatives Bild der Vorlage, wobei sowohl bei A als auch bei B die Stufen 1 - 5 voll farbannehmend sind.

Beispiel 8

Dieses Beispiel zeigt den Einfluß der Dicke der Deckschicht auf das Auflösungsvermögen des erfindungsgemäßen Aufzeichnungsmaterials.

Entsprechend Beispiel 1 werden Platten hergestellt, wobei durch Variation der Schleuderdrehzahl verschiedene Schichtdicken für die Deckschicht erhalten werden. Es wird wie in Beispiel 1 durch einen UGRA-Offset-Testkeil 10 Sekunden belichtet und entwickelt. Tabelle 5 gibt die Ergebnisse wieder.

Tabelle 5

| Deckschichtdicke | voll gedeckte Stufen | Wiedergabe der Mikrolinien |
|---|---|---|
| nm | | mm |
| 0 | 9 | 0,010 |
| 200 | 9 | 0,010 |
| 660 | 9 | 0,012 |
| 1.000 | 9 | 0,012 |
| 2.000 | 9 | 0,015 |
| 3.000 | 9 | 0,020 |
| 5.000 | 9 | 0,025 |

Alle Platten mit Deckschicht waren nach 10-stündiger Lagerung bei 100° C noch einwandfrei entwickelbar und tonten nicht.

Beispiel 9

Dieses Beispiel zeigt die Eignung des erfindungsgemäßen Materials als Ätzreserve.
Auf eine Kupferplatte wird die folgende Lösung durch Schleudern aufgebracht:

40 Gt Novolak wie in Beispiel 1,
11,7 Gt Polyacetal aus Triethylenglykol und Butyraldehyd,
0,50 Gt 2-(4-Ethoxy-naphth-1-yl)-4,6-bis-trichlormethyl-s-triazin und
0,10 Gt Kristallviolett-Base in
50,0 Gt Ethanol und
60,0 Gt Butanon.

Nach 10 Minuten Trocknen bei 100° C resultiert eine Schichtdicke von 0,025 mm. Auf diese strahlungsempfindliche Schicht wird eine Deckschicht wie in Beispiel 1 in einer Dicke von 1.000 nm aufgeschleudert. Es wird mit einer 5 kW-Metallhalogenid-Lampe (110 cm Abstand) ca. 50 Sekunden belichtet und nach einer Wartezeit von 15 Minuten 90 Sekunden mit dem in Beispiel 1 angegebenen Entwickler entwickelt. Die entstandene Resistschablone weist eine hervorragende Ätz- und Galvanoresistenz auf, insbesondere beim galvanischen Aufbau von Kupfer und Pb/Sn-Legierung.

Beispiel 10

Dieses Beispiel zeigt die Eignung des erfindungsgemäßen Aufzeichnungsmaterials als hochauflösende Photoresistschablone.
Auf einen mit einem $SiO_2$-Film bedeckten Silicium-Wafer wird die folgende, durch ein Filter mit einem Porendurchmesser von 200 nm filtrierte Lösung durch Schleudern aufgebracht:

12,5 Gt Novolak wie in Beispiel 1,
2,1 Gt Polyacetal wie in Beispiel 1 und
0,1 Gt 2-(4-Styrylphenyl)-4,6-bis-trichlormethyl-s-triazin in
85,0 Gt 2-Ethoxy-ethylacetat.

Nach 1 Minute Trocknen bei 100° C wird eine Dicke von 1000 nm erhalten. Auf diese strahlungsempfindliche Schicht wird eine Deckschicht wie in Beispiel 1 in einer Dicke von 100 nm aufgeschleudert. Eine Testbildmaske wird in innigen Kontakt mit dem Wafer gebracht, der 15 Sekunden mit UV-Licht einer Intensität von 4,5 mW/cm$^2$ bei 365 nm belichtet wird. Nach 10 Minuten Warten wird 45 Sekunden mit dem Entwickler aus Beispiel 1 entwickelt. Das erhaltene Bildmuster zeigt eine Auflösung von 1000 nm.

Beispiel 11

Dieses Beispiel zeigt die Eignung des erfindungsgemäßen Aufzeichnungsmaterials für die Bebilderung mit Elektronenstrahlen.

Auf mechanisch aufgerauhtes Aluminium wird eine Lösung folgender Zusammensetzung aufgeschleudert:

| | |
|---|---|
| 4,0 Gt | Novolak wie in Beispiel 1, |
| 1,2 Gt | Bis-(5-butyl-5-ethyl-1,3-dioxan-2-yl)-ether des 2-Butyl-2-ethyl-propandiols, |
| 0,20 Gt | 2-(4-Ethoxy-naphth-1-yl)-4,6-bis-trichlormethyl-s-triazin und |
| 0,02 Gt | Kristallviolett-Base in |
| 94,60 Gt | Butanon |

Es wird eine Schichtdicke von 1000 nm erhalten. Auf diese strahlungsempfindliche Schicht wird eine Deckschicht wie in Beispiel 5 in einer Dicke von 200 nm aufgeschleudert. Die Bestrahlung erfolgt mit 11 kV-Elektronen. Bei einem Strahlstrom von $5 \cdot 10^{-6}$ A reichen 4 Sekunden Bestrahlungsdauer aus, um ein Feld von 10 Quadratzentimetern nach 90 Sekunden Einwirkung des Entwicklers aus Beispiel 1 löslich zu machen. Dies entspricht einer Empfindlichkeit der oben genannten Schichten von $2 \cdot 10^{-6}$ C/cm$^2$.

**Patentansprüche**

1. Strahlungsempfindliches Aufzeichnungsmaterial mit einem Schichtträger und einer strahlungsempfindlichen Schicht, die als wesentliche Bestandteile
   a) eine unter Einwirkung von aktinischer Strahlung eine starke Säure bildende Verbindung,
   b) eine Verbindung mit mindestens einer durch Säure spaltbaren C-O-C-Bindung und
   c) ein polymeres Bindemittel
   enthält, dadurch gekennzeichnet, daß sich auf der strahlungsempfindlichen Schicht eine Deckschicht befindet, die ein Polymeres enthält, das beim Entwickeln der strahlungsempfindlichen Schicht zusammen mit den Nichtbildstellen entfernbar ist.

2. Aufzeichnungsmaterial nach Anspruch 1, dadurch gekennzeichnet, daß das Polymere im Entwickler löslich ist.

3. Aufzeichnungsmaterial nach Anspruch 1, dadurch gekennzeichnet, daß die Deckschicht 10 nm bis 0,05 mm dick ist.

4. Aufzeichnungsmaterial nach Anspruch 1, dadurch gekennzeichnet, daß die Deckschicht ferner eine oberflächenaktive Substanz enthält.

5. Aufzeichnungsmaterial nach Anspruch 1, dadurch gekennzeichnet, daß das Polymere der Deckschicht ein Vinylalkohol-, N-Vinyllactam- oder N-Vinylcarbonsäureamidpolymerisat ist.

6. Aufzeichnungsmaterial nach Anspruch 1, dadurch gekennzeichnet, daß das polymere Bindemittel (c) wasserunlöslich und in wäßrig-alkalischen Lösungen löslich ist.

7. Aufzeichnungsmaterial nach Anspruch 1, dadurch gekennzeichnet, daß die Verbindung (b) mindestens eine Orthocarbonsäureester-, Carbonsäureamidacetal-, Acetal-, Ketal-, Enolether- oder Acyliminocarbonatgruppierung enthält.

8. Aufzeichnungsmaterial nach Anspruch 1, dadurch gekennzeichnet, daß die strahlungsempfindliche Schicht eine Dicke im Bereich von 500 nm bis 0,08 mm hat.

9. Aufzeichnungsmaterial nach Anspruch 1, dadurch gekennzeichnet, daß die strahlungsempfindliche Schicht 30 bis 90 Gew.-% polymeres Bindemittel (c), 5 bis 70 Gew.-% säurespaltbare Verbindung (b) und 0,1 bis 10 Gew.-% durch Bestrahlung Säure bildende Verbindung (a) enthält.

**10.** Aufzeichnungsmaterial nach Anspruch 1, dadurch gekennzeichnet, daß sich zwischen dem Schichtträger und der strahlungsempfindlichen Schicht eine weitere strahlungsempfindliche Schicht befindet, die als strahlungsempfindliche Verbindung ein 1,2-Chinondiazid enthält.

**Claims**

**1.** A radiation-sensitive recording material comprising a support and a radiation-sensitive layer that contains as the essential constituents
   a) a compound which forms a strong acid under the action of actinic radiation,
   b) a compound which has at least one acid-cleavable C-O-C bond and
   c) a polymeric binder,
characterized in that on top of the radiation-sensitive layer there is provided a cover layer containing a polymer which during the development of the radiation-sensitive layer can be removed together with the non-image areas.

**2.** A recording material as claimed in claim 1, characterized in that the polymer is soluble in the developer.

**3.** A recording material as claimed in claim 1, characterized in that the cover layer has a thickness in the range from 10 nm to 0.05 mm.

**4.** A recording material as claimed in claim 1, characterized in that the cover layer furthermore contains a surface-active substance.

**5.** A recording material as claimed in claim 1, characterized in that the polymer of the cover layer is a polymer of vinyl alcohol, vinyl lactam or N-vinylcarboxylic acid amide.

**6.** A recording material as claimed in claim 1, characterized in that the polymeric binder (c) is insoluble in water and soluble in aqueous-alkaline solutions.

**7.** A recording material as claimed in claim 1, characterized in that compound (b) comprises at least one orthocarboxylic acid ester, carboxylic acid amide acetal, acetal, ketal, enolic ether or acyl-iminocarbonate grouping.

**8.** A recording material as claimed in claim 1, characterized in that the radiation-sensitive layer has a thickness in the range from 500 nm to 0.08 mm.

**9.** A recording material as claimed in claim 1, characterized in that the radiation-sensitive layer comprises from 30 to 90 percent by weight of polymeric binder (c), from 5 to 70 percent by weight of acid-cleavable compound (b) and from 0.1 to 10 percent by weight of compound (a) which forms an acid under the action of radiation.

**10.** A recording material as claimed in claim 1, characterized in that a further radiation-sensitive layer comprising a 1,2-quinone diazide as the radiation-sensitive compound is present between the support and the radiation-sensitive layer.

**Revendications**

**1.** Matériau d'enregistrement sensible aux rayonnements comprenant un support et une couche sensible aux rayonnements qui contient comme constituants essentiels :
   a) un composé qui forme un acide fort sous l'action d'un rayonnement actinique,
   b) un composé qui a au moins une liaison C-O-C séparable en milieu acide et
   c) un liant polymère,
caractérisé en ce que la surface supérieure de la couche sensible aux rayonnements est pourvue d'une couche de revêtement contenant un polymère qui peut être éliminé simultanément avec les zones de non-image pendant le développement de la couche sensible aux rayonnements.

**2.** Matériau d'enregistrement selon la revendication 1, caractérisé en ce que le polymère est soluble dans le révélateur.

3. Matériau d'enregistrement selon la revendication 1, caractérisé en ce que la couche de revêtement a une épaisseur comprise entre 10 nm et 0.05 mm.

4. Matériau d'enregistrement selon la revendication 1, caractérisé en ce que la couche de revêtement contient en outre une substance tensioactive.

5. Matériau d'enregistrement selon la revendication 1, caractérisé en ce que le polymère de la couche de revêtement est un polymère d'alcool vinylique, de lactame vinylique, ou d'amide de l'acide N-vinylcarboxylique.

6. Matériau d'enregistrement selon la revendication 1, caractérisé en ce que le liant polymère (c) est insoluble dans l'eau et soluble dans des solutions aqueuses alcalines.

7. Matériau d'enregistrement selon la revendication 1, caractérisé en ce que le composé (b) comprend au moins un groupement ester d'acide orthocarboxylique, acétal d'amide d'acide carboxylique, acétal, cétal, éther énolique ou acyl-iminocarbonate.

8. Matériau d'enregistrement selon la revendication 1, caractérisé en ce que la couche sensible aux rayonnements a une épaisseur comprise entre 500 nm et 0.08 mm.

9. Matériau d'enregistrement selon la revendication 1, caractérisé en ce que la couche sensible aux rayonnements comprend de 30 à 90% en poids de liant polymère (c), de 5 à 70% en poids de composé (b) séparable en milieu acide et de 0.1 à 10% en poids d'un composé (a) qui forme un acide sous l'action d'un rayonnement.

10. Matériau d'enregistrement selon la revendication 1, caractérisé en ce qu'une couche sensible aux rayonnements supplémentaire comprenant un 1,2-quinone diazide comme composé sensible aux rayonnements est présente entre le support et la couche sensible aux rayonnements.